(19) Europäisches Patentamt / European Patent Office / Office européen des brevets

(11) **EP 3 167 297 B1**

(12) **EUROPÄISCHE PATENTSCHRIFT**

(45) Veröffentlichungstag und Bekanntmachung des Hinweises auf die Patenterteilung:
**27.10.2021  Patentblatt 2021/43**

(21) Anmeldenummer: **14758945.1**

(22) Anmeldetag: **04.09.2014**

(51) Int Cl.:
**G01R 31/333** (2006.01)    **G01R 31/327** (2006.01)

(86) Internationale Anmeldenummer:
**PCT/EP2014/068811**

(87) Internationale Veröffentlichungsnummer:
**WO 2016/034230 (10.03.2016 Gazette 2016/10)**

(54) **PRÜFSCHALTUNG FÜR HOCHLEISTUNGS-HALBLEITERELEMENT**

TEST CIRCUIT FOR A HIGH-POWER SEMICONDUCTOR ELEMENT

CIRCUIT DE CONTRÔLE D'UN ÉLÉMENT SEMI-CONDUCTEUR HAUTE PUISSANCE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**17.05.2017   Patentblatt 2017/20**

(73) Patentinhaber: **Siemens Energy Global GmbH & Co. KG**
**81739 München (DE)**

(72) Erfinder:
• **HAHN, Christoph**
  **91052 Erlangen (DE)**
• **LUTHER, Matthias**
  **91052 Erlangen (DE)**
• **NEUBERT, Rolf**
  **90763 Fürth Bay (DE)**
• **UDER, Markus**
  **91466 Gerhardshofen (DE)**
• **MÜLLER, Sebastian**
  **91052 Erlangen (DE)**

• **SEMEROW, Anatoli**
  **91058 Erlangen (DE)**
• **WEINDL, Christian**
  **96450 Coburg (DE)**
• **WENDLER, Thomas**
  **97500 Ebelsbach - Gleisenau (DE)**

(56) Entgegenhaltungen:
WO-A1-2010/145692    WO-A1-2013/071947
CN-A- 103 197 241    CN-B- 102 129 034
CN-B- 102 565 579

• NHO EUI-CHEOL ET AL: "Synthetic Test Circuit for Thyristor Valve in HVDC Converter with New High-Current Source", IEEE TRANSACTIONS ON POWER ELECTRONICS, INSTITUTE OF ELECTRICAL AND ELECTRONICS ENGINEERS, USA, Bd. 29, Nr. 7, 1. Juli 2014 (2014-07-01), Seiten 3290-3296, XP011540382, ISSN: 0885-8993, DOI: 10.1109/TPEL.2013.2279716 [gefunden am 2014-02-17]

**Beschreibung**

Die Erfindung betrifft eine Prüfschaltung für ein Hochleistungs-Halbleiterelement in Stromrichtern für die Hochspannungs-Gleichstrom-Übertragung, umfassend einen Hochspannungskreis mit einem Anschluss für das Hochleistungs-Halbleiterelement und einer mit dem Hochleistungs-Halbleiterelement verbindbaren Hochspannungsquelle. Sie betrifft weiter ein Verfahren zur Prüfung eines Hochleistungs-Halbleiterelements.

Die Hochspannungs-Gleichstrom-Übertragung (HGÜ) dient insbesondere der Energieübertragung mittels Gleichstrom über weite Entfernungen - in der Regel Entfernungen von rund 750 km aufwärts. Hierfür ist zwar ein vergleichsweise hoher technischer Aufwand für hochspannungstaugliche, aufwendige Stromrichter vonnöten, da elektrische Energie in Kraftwerken fast immer durch Synchron-Generatoren als Dreiphasenwechselstrom der Frequenz 50 Hz bzw. 60 Hz erzeugt wird. Allerdings führt die HGÜ ab bestimmten Entfernungen trotz des technischen Aufwands und der zusätzlichen Konverterverluste zu in der Summe geringeren Übertragungsverlusten als die Übertragung mit Dreiphasenwechselstrom.

Die internationale Patentanmeldung WO 2010/145692 A1 offenbart eine Testschaltung für Halbleiterbauelemente, die in einem Submodul eines modularen Multilevelkonverters angeordnet sind. Die Testschaltung weist die Form einer einphasigen Back-to-back-Schaltung auf. Diese Testschaltung weist 4 Reihenschaltungen von Submodulen auf. In zwei dieser Reihenschaltungen ist jeweils ein Submodul mit den zu prüfenden Halbleiterbauelementen angeordnet.

Aus der chinesischen Patentanmeldung CN 103197241A ist eine Prüfschaltung für elektrische Ventile von modularen Multilevelkonvertern bekannt. Diese Prüfschaltung weist zwei Submodule auf, die jeweils von einer zugehörigen Spannungsquelle mit Energie versorgt werden. Weiterhin weist die Prüfschaltung zwei Reihenschaltungen aus Submodulen auf. Diese Reihenschaltungen werden mittels einer dritten Spannungsquelle mit Energie versorgt. Die dritte Spannungsquelle ist über einen ladestrombegrenzenden Widerstand mit den Reihenschaltungen verbunden. Die Submodule sind jeweils Halbbrücken-Submodule.

Die chinesische Patentschrift CN 102129034B offenbart eine Prüfschaltung für ein elektrisches Ventil, das für eine Hochspannungsgleichstromübertragung einsetzbar ist. Die Prüfschaltung weist eine Reihenschaltung von Submodulen auf, wobei die Reihenschaltung eine Wechselspannung erzeugt, mit der das Ventil beaufschlagt wird.

Aus der chinesischen Patentschrift CN 102565579B ist eine Testschaltung bekannt, die zwei Reihenschaltungen aus H-Brücken-Submodulen aufweist. Die beiden Reihenschaltungen sind jeweils mit einer Induktivität in Serie geschaltet. Die beiden Reihenschaltungen sind mit einer einphasigen Wechselspannungsquelle verbunden, wobei die Wechselspannungsquelle über einen überbrückbaren Strombegrenzungswiderstand mit den Reihenschaltungen verbunden ist.

Die in den Stromrichtern oder in Statischen Blindleistungskompensatoren verwendeten Hochleistungs-Halbleiterelemente, insbesondere die Thyristorventile, müssen Leistungsprüfungen unterzogen werden. Dies erfolgt entweder in einer so genannten Back-to-back-Verbindung, bei der Gleich- und Wechselrichter "Rücken an Rücken" stehen, also im Gegensatz zu anderen HGÜ Anlagen, bei denen - wie oben beschrieben - oft große Distanzen zwischen den Stationen liegen, räumlich kaum voneinander getrennt sind, oder mittels einer synthetischen Prüfschaltung, d. h. konstruierten Prüfschaltungen, in denen der Prüfling angeschlossen werden kann und in die die Spannungs- und Stromverläufe, denen der Prüfling im realen Betrieb unterliegt, nachbilden.

Durch die immer weiter ansteigende Übertragungsleistung von heutigen HGÜ-Systemen müssen für die Prüfung benötigte Back-to-back-Prüfeinrichtungen allerdings vergleichsweise groß dimensioniert und für die entsprechende Leistung ausgelegt sein. Synthetische Prüfschaltungen, wie sie beispielsweise aus IEC 60700-1, "Thyristor valves for high voltage direct current (HVDC) power transmission, Part1: Electrical Testing" IEC (International Electrotechnical Commission), Geneva, 2008; aus IEC 61954, "Static var compensators (SVC) - Testing of thyristor valves," IEC (International Electrotechnical Commission), Geneva, 2011; und aus IEEE (Institute of Electrical and Electronics Engineers), "IEEE 857, Guide for Testing of Thyristor Valves," IEEE, 1996 bekannt sind, benötigen hingegen nur 1 bis 2 % der Auslegungsgröße von vergleichbaren Back-to-back-Prüfsystemen, indem sie einen separaten Hochstrom- und Hochspannungskreis verwenden, die jeweils mit dem Prüfling verbindbar sind (d. h. über einen entsprechend ansteuerbaren Schalter oder ein Ventil mit diesem verbunden sind).

Die bisher bekannten synthetischen Prüfschaltungen umfassen hierbei einen oder mehrere LC-Schwingkreise zur Erzeugung der Hochspannung und daneben einen Hochstromkreis, der seinen Strom über einen Transformator aus dem Versorgungsnetz bezieht. Hierbei sind leicht unterschiedliche Konzepte auf der genannten Basis "Schwingkreis/Hochstrom" bekannt. Ein bekanntes Konzept der Anmelderin nutzt einen Freilaufpfad, der aus der Hochspannungsquelle getrieben wird, zur Überlagerung des Hochstromes. Andere bekannte Systeme nutzen ihren Schwingkreis nur zum Ein- und Ausschalten des Prüflings, während in der Hochstrom-Phase die Hochspannung mit einem Hilfsventil vom Prüfling getrennt wird.

In beiden Varianten sind die Ausschalt-Parameter des Prüflings von den Einschalt-Parametern abhängig und schränken so die Einstellung der Prüfbedingungen stark ein. Bedingt durch die Nachladung der Schwingkreise in Zusammenhang mit dem Hochstromkreis sind die aktuellen synthetischen Prüfschaltungen von der Netzfrequenz abhängig, d. h. auch Prüflinge, die später in einem 60-Hz-Netz betrieben werden, können bei der Prüfung nur bei 50 Hz belastet werden, so dass Anpassungen der Parameter nötig sind.

Es ist somit Aufgabe der Erfindung, eine Prüfschaltung und ein Verfahren der eingangs genannten Art anzugeben, die eine besonders flexible Einstellung der Prüfbedingungen erlauben und insbesondere unabhängig von der Netzfrequenz funktionieren.

Diese Aufgabe wird bezüglich der Prüfschaltung erfindungsgemäß gelöst, indem die Hochspannungsquelle eine Mehrzahl von in einer ersten Reihe geschalteten spannungsgeführten Stromrichtermodulen umfasst.

Die Erfindung geht dabei von der Überlegung aus, dass eine besonders flexible Einstellung der Prüfbedingungen durch die Verwendung einer flexibleren Spannungsquelle während der Prüfung möglich wäre. Hierbei hat sich herausgestellt, dass insbesondere die bislang verwendeten, auf netzgeführten Stromrichtern (englisch: Line-commutated Converter, kurz LCC) basierenden Systeme nicht die benötigte Flexibilität aufweisen, da sie zwingend von der Netzfrequenz abhängig sind. Eine Unabhängigkeit von der Netzfrequenz wird dadurch gegeben, dass eine frei steuerbare Hochspannungsquelle mit spannungsgeführten Stromrichtermodulen (englisch: Voltage-Source Converter, kurz VSC) verwendet werden. Hierunter wird ein Modul verstanden, das eine Gleichspannungsquelle in der Art einer Batterie umfasst, dessen Spannungswert an den Anschlüssen durch entsprechende Ansteuerung von ebenfalls im Modul enthaltenen Schaltern mit einer Steuerspannung variiert werden kann. Mit diesen Modulen ist es möglich, die realen Betriebs-SpannungsVerläufe für ein zu prüfendes LCC-Ventil praktisch beliebig (mit der Diskretisierung der Spannung eines der Module) nachzubilden. Es ist keine Hardwareanpassung für 50-Hz- oder 60-Hz-Anwendung mehr nötig.

Die Prüfschaltung umfasst weiterhin eine in eine zweite Reihe geschaltete Mehrzahl von spannungsgeführten Stromrichtermodulen, die mit der Primärseite eines Hochstromtransformators verbunden ist und bei dem die Sekundärseite des Hochstromtransformators mit dem Hochleistungs-Halbleiterelement verbindbar ist. Dadurch kann auch eine Hochstromprüfung des Prüflings erfolgen. Durch den Hochstromtransformator, der mit einem Wicklungsverhältnis von drei oder mehr ausgebildet ist, kann ein an der Primärseite fließender Strom vervielfacht werden. Durch die Ansteuerung des Hochstromtransformators mittels der Spannung aus der zweiten Reihe von spannungsgeführten Stromrichtermodulen, die natürlich ebenso frei steuerbar sind, kann auch eine vollkommen flexible Stromprüfung des Prüflings erfolgen.

Vorteilhafterweise ist die zweite Reihe von Stromprüfungsmodulen mit der ersten Reihe in Serie geschaltet. Dies ermöglicht ein gemeinsames Aufladen der beiden Reihen mit der benötigten Spannung.

Die im Folgenden beschriebenen Strukturen von spannungsgeführten Stromrichtermodulen gelten bevorzugt für jedes der spannungsgeführten Stromrichtermodule. Die spannungsgeführten Stromrichtermodule sind vorzugsweise identisch ausgebildet. Vorzugsweise umfasst das jeweilige spannungsgeführte Stromrichtermodul einen Kondensator und vier Transistoren in einer Vollbrücke, d. h. jeweils zwei in gleicher Richtung seriell geschaltete Transistoren, zwischen denen einer der externen Anschlüsse angeordnet ist, sind in gleicher Richtung miteinander und zum Kondensator parallel geschaltet. Hierdurch ergibt sich eine Form in der Art eines H.

Vorzugsweise ist der jeweilige, insbesondere jeder Transistor ein Bipolartransistor mit isolierter Gate-Elektrode. Diese eignen sich besonders für die hier vorgesehene Anwendung im Hochleistungsbereich, da sie über eine hohe Vorwärts-Sperrspannung (derzeit bis 6,6 kV) verfügen und hohe Ströme (bis etwa 3 kA) schalten können.

Das jeweilige, vorzugsweise jedes spannungsgeführte Stromrichtermodul ist vorzugsweise für eine Nennspannung von mehr als 800 V und/oder einen Nennstrom von mehr als 500 A ausgelegt. Hierdurch wird eine übermäßig große Anzahl von Modulen vermieden. Bei niedrigeren Nennspannungen müssten zur Erreichung der notwendigen Spannungen von mehr als 50 kV für die Prüfung sonst zu viele Module verwendet werden.

In vorteilhafter Ausgestaltung umfasst die Prüfschaltung mehr als zehn, bevorzugt mehr als dreißig spannungsgeführte Stromrichtermodule. Einerseits können mit einer höheren Anzahl höhere Gesamtspannungen über die jeweilige Reihe erreicht werden, andererseits können durch eine hohe Anzahl feinere diskrete Spannungssprünge beim Erzeugen einer Spannungskurve für die Prüfung erreicht werden.

Die Prüfschaltung umfasst weiterhin vorteilhafterweise einen netzgespeisten Gleichrichter, der mit der Hochspannungsquelle verbindbar ist. Mittels eines derartigen Gleichrichters können die in den Reihen angeordneten spannungsgeführte Stromrichtermodule bzw. die in ihnen angeordneten Kondensatoren aufgeladen werden.

Dem Gleichrichter ist dabei bevorzugt ein Hochspannungstransformator vorgeschaltet, der weiter bevorzugt für eine Ausgangsspannung von mehr als 25 kV ausgelegt ist. Hierdurch können die für die Prüfung benötigten Spannungen in der Hochspannungsquelle einfach erreicht werden.

Das in der Prüfschaltung geprüfte Hochleistungs-Halbleiterelement ist vorzugsweise ein Thyristor, wie er in einem netzgeführten Stromrichter insbesondere für die Hochspannungs-Gleichstrom-Übertragung zur Anwendung kommt.

Bezüglich des Verfahrens wird die Aufgabe gelöst durch ein Verfahren zur Prüfung eines Hochleistungs-Halbleiterelements, bei dem eine Prüfverlaufsspannungskurve für eine Hochspannungsprüfung des Hochleistungs-Halbleiterelements vorgegeben wird, und bei dem die vorgegebene Prüfverlaufsspannungskurve durch Ansteuerung von spannungsgeführten Stromrichtermodulen in einer ersten Reihe nachgebildet wird. Bei diesem Verfahren wird zunächst eine Prüfverlaufsspannungskurve für eine Hochspannungsprüfung des Hochleistungs-Halbleiterelements vorgegeben (Prüfplan). Hierbei werden beim Ein- und Ausschalten des Prüflings unabhängig die Spannungen korrekt eingestellt, und die Prüfverlaufsspannungskurve bildet auch die in der Sperrphase typischen Spannungssprünge, die im Anlagenbetrieb durch die Kommutierungen der Nachbarventile entstehen, abgebildet. Die vorgegebene Prüfverlaufsspannungskurve wird dann durch Ansteuerung der spannungsgeführten Stromrichtermodule der ersten Reihe nachgebildet. Dies erfolgt durch entsprechende Ansteuerung der Steuerelektronik der spannungsgeführten Stromrichtermodule die entweder keine oder wahlweise positive/negative Spannung des Kondensators an ihren Ausgängen anlegen können. Durch entsprechende Kombination von Schaltstellungen wird durch die Addition der Spannungen in der Reihe die gewünschte Spannung zum gewünschten Zeitpunkt eingestellt. Maximum ist hierbei die Addition aller Spannungen, und die Spannung kann nur in diskreten Abständen von einer Spannung eines der Kondensatoren der spannungsgeführten Stromrichtermodule eingestellt werden.

Dabei wird auch eine Prüfverlaufsstromkurve für eine Hochstromprüfung des Hochleistungs-Halbleiterelements vorgegeben, die sodann im Rahmen der Prüfung durch Ansteuerung der spannungsgeführten Stromrichtermodule der zweiten Reihe nachgebildet wird. Da diese mit dem Hochstromtransformator verbunden sind, kann hierdurch ein hoher Strom durch den Prüfling erreicht werden, dessen Verlauf ebenfalls durch die beliebige Ansteuerbarkeit der spannungsgeführten Stromrichtermodule vollkommen flexibel ist.

Die mit der Erfindung erzielten Vorteile bestehen insbesondere darin, dass durch den Einsatz der VSC-Module die Prüf-Hochspannung flexibel zu jedem Zeitpunkt der Periode eingestellt werden kann. Der Spannungsbereich beläuft sich von nahezu 0 V bis zur maximal ausgelegten Spannung der Prüfschaltung, in der Anwendung der Anmelderin ca. ±70 kV. Hierdurch können alle Prüfschritte nach Normen IEC 60700-1 und IEC 61954 von "Minimal-Spannungsbetrieb" über "Nennbetrieb" bis hin zum "Maximal-Spannungsbetrieb" in einem Prüfdurchlauf abgearbeitet werden. Erneute Dimensionierungen einer Schwingkreisschaltung oder die Anpassung von Hilfsventilen für jeden einzelnen Prüfschritt sind nicht nötig. Die neue Schaltung ist auch frequenzunabhängig, da die Leistung aus den Modulkondensatoren genommen wird, die quasi kontinuierlich nachgeladen werden.

Durch die Nutzung eines Hochstromtransformators ist die Dimensionierung des Hochstromkreises sehr einfach: Da der Hochstromtransformator aus den Speicherkondensatoren der VSC-Module gespeist wird, ergeben sich sehr geringe Rückwirkungen auf das speisende Netz. Es werden lediglich die Verluste von Prüfling und Prüfschaltung aus dem Netz entnommen.

Ausführungsbeispiele der Erfindung werden anhand einer Zeichnung näher erläutert. Darin zeigen:

FIG 1   einen Schaltplan einer synthetischen Prüfschaltung,

FIG 2   einen Schaltplan eines VSC-Moduls, und

FIG 3   eine graphische Darstellung von Spannung und Strom in einer Simulation der synthetischen Prüfschaltung.

Gleiche Teile sind in allen Figuren mit denselben Bezugszeichen versehen.

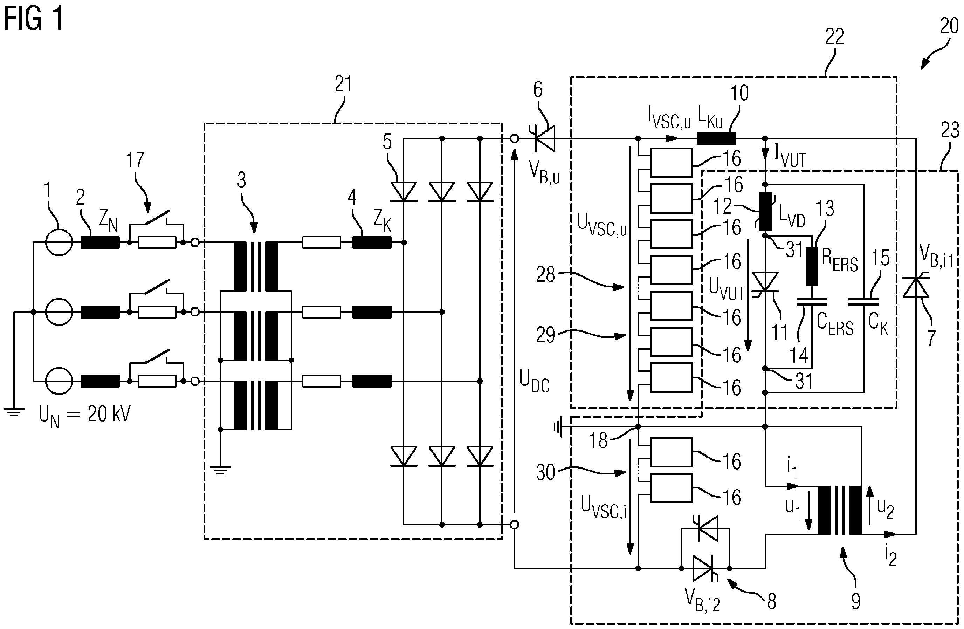

FIG 1 zeigt einen schematischen Schaltplan einer synthetischen Prüfschaltung 20 für ein Hochleistungs-Halbleiterelement 11, wie es in Stromrichtern für die Hochspannungs-Gleichstrom-Übertragung zur Anwendung kommt. In der linken Hälfte der FIG 1 ist ein übliches 20-kV-Wechselstromnetz gezeigt, welches durch eine dreiphasige Spannungsquelle 1 repräsentiert wird, in der FIG 1 dargestellt durch drei jeweils um 120 Grad phasenverschobene Spannungsquellen 1 in parallelen Stromwegen. Das 20-kV-Wechselstromnetz weist ebenfalls eine Netzimpedanz 2 auf, die mit $Z_n$ bezeichnet ist und ebenfalls in jedem der drei parallelen Stromwege an die Spannungsquellen 1 anschließend dargestellt ist.

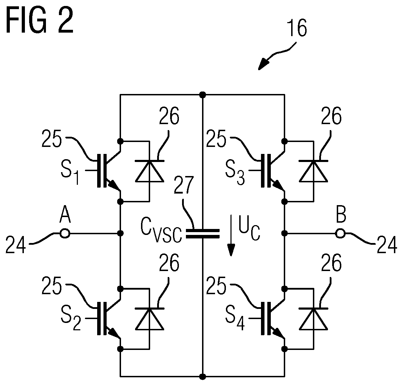

In den drei Stromwegen folgt als nächstes ein bedarfsweise schaltbar überbrückbarer Ladewiderstand 17 für die noch im Folgenden anhand der FIG 1 und FIG 2 noch erläuterten VSC-Module 16 (spannungsgeführte Stromrichtermodule) zu Beginn des Betriebs. Das 20-kV-Wechselstromnetz speist eine Hochgleichspannungsquelle 21, welche ausgehend vom Wechselstromnetz zunächst einen Dreiphasentransformator 3 speist. Die Hochgleichspannungsquelle 21 weist eine mit $Z_k$ bezeichnete Kommutierungsimpedanz 4 auf, die im Anschluss an den Dreiphasentransformator 3 anschließend dargestellt ist.

Die Hochgleichspannungsquelle 21 weist im Ausführungsbeispiel einen ungesteuerten Sechspulsgleichrichter 5 auf, der als Diodenbrücke in der Bauform B6 mit sechs Dioden ausgebildet ist. Andere Ausführungsformen können hierbei selbstverständlich auch andere Gleichrichter verwenden, so z. B. mit größeren Anzahlen von Dioden oder gesteuerte Gleichrichter. Die Hochgleichspannungsquelle 21 fungiert als Ladesystem für die VSC-Module 16 während des Prüfbetriebs und stellt die Gleichspannung $U_{DC}$ zur Verfügung.

Die Gleichspannung $U_{DC}$ ist über ein Sperrventil 6 an eine Reihe seriell geschalteter VSC-Module 16 angelegt. Diese bilden die eigentliche Hochspannungsquelle 28 für den im Folgenden noch erläuterten Prüfbetrieb und werden durch die Hochgleichspannungsquelle 21 lediglich vorab aufgeladen. Das Sperrventil 6 ist als Thyristor in Sperrrichtung mit der Bezeichnung $V_{B,u}$ ausgebildet und sperrt die Gleichspannung $U_{DC}$ während der im Folgenden noch erläuterten Spannungsprüfung von den VSC-Modulen 16 ab. Zwischen zwei VSC-Modulen 16 der Reihe ist eine Erdung 18 vorgesehen, die den Trennpunkt zwischen Hochspannungskreis 22 (VSC-Module 16 zwischen Sperrventil 6 und Erdung 18) und Hochstromkreis 23 (VSC-Module 16 zwischen Erdung 18 und positivem Pol der Hochgleichspannungsquelle 21) bildet. Die VSC-Module 16 werden damit in eine erste Reihe 29 des Hochspannungskreises 22 und eine zweite Reihe 30 des Hochstromkreises 23 getrennt.

Im nur schematisch dargestellten Schaltplan ist die Anzahl der VSC-Module 16 hierbei nicht festgelegt, unterschiedliche Ausführungsbeispiele können unterschiedliche (feste) Anzahlen von VSC-Modulen 16 vorsehen: Es ist eine Mehrzahl von $n_{VSC,u}$ VSC-Modulen 16 im Hochspannungskreis 22 und eine Mehrzahl von $n_{VSC,i}$ VSC-Modulen 16 im Hochstromkreis 23 vorgesehen, wobei die Gesamtzahl der VSC-Module damit $n_{VSC} = n_{VSC,u} + n_{VSC,i}$ beträgt. Über der Reihe 29 der $n_{VSC,u}$ VSC-Module 16 im Hochspannungskreis 22 liegt die Spannung $U_{VSC,u}$ an, Über der Reihe 30 der $n_{VSC,i}$ VSC-Module 16 im Hochstromkreis 23 liegt die Spannung $U_{Vsc,i}$ an.

Das Hochleistungs-Halbleiterelement 11, welches den auch mit VUT (Valve under Test) bezeichneten Prüfling darstellt, ist an den Anschlüssen 31 in einer sogleich beschriebenen Schaltung mit dem Hochspannungskreis 22 verbunden, indem diese den $n_{VSC,u}$ VSC-Modulen 16 im Hochspannungskreis 22 zwischen Sperrventil 6 und Erdung 18 über eine Kommutierungsdrossel 10 mit der Induktivität $L_{Ku}$ parallel geschaltet ist.

Die Schaltung des über die Anschlüsse 31 angeschlossenen Prüflings (im Ausführungsbeispiel ein Thyristor) umfasst dabei ein seriell vor dem Hochspannungs-Halbleiterelement 11 angeordnetes Sättigungsdrosselventil 12 mit der Induktivität $L_{VD}$, welches die Stromanstiegsgeschwindigkeit zum Prüfling zu Beginn des Stromflusses begrenzt und erst durch Eintreten der Sättigung seine Induktivität im Wesentlichen verliert. Weiterhin ist zu dem Prüfling und seinem vorgeschalteten Sättigungsdrosselventil 12 ein Steuerkondensator 15 mit der Kapazität $C_K$ parallel geschaltet.

Der in FIG 1 dargestellte Schaltplan zeigt zudem als Ersatzschaltbild parallel zum Prüfling geschaltet einen Widerstand 13 und einen Kondensator 14, die den Ersatzwiderstand $R_{ERS}$ bzw. die Ersatzkapazität $C_{ERS}$ des Prüflings darstellen. Ersatzwiderstand $R_{ERS}$ bzw. Ersatzkapazität $C_{ERS}$ des Prüflings sind in der FIG 1 zwar als reale Bauteile dargestellt, sind aber - wie bei Ersatzschaltbildern üblich - im Gegensatz zu den übrigen beschriebenen Bauteilen nicht in der realen Schaltung vorhanden, sondern stellen lediglich eine Repräsentation von intrinsischen Eigenschaften des Prüflings zu Zwecken der Darstellung und Berechnung dar. Der zur Kommutierungsdrossel 10 fließende Strom wird mit $I_{VSC,u}$ bezeichnet, der zum Prüfling fließende Strom mit $I_{VUT}$ und die über die Schaltung des Prüflings anliegende Spannung mit $U_{VUT}$.

Die $n_{VSC,i}$ VSC-Module 16 im Hochstromkreis 23 sind über ein antiparalleles, mit $V_{B,i2}$ bezeichnetes Sperrthyristorpaar 8 mit der Primärseite eines Hochstromtransformators 9 verbunden. Mit anderen Worten: Ein Pol der Primärseite des Hochstromtransformators 9 ist mit der Erdung 18, der andere Pol über das Sperrthyristorpaar 8 mit dem positiven Pol der Hochspannungsquelle 21 verbunden. Auf der Primärseite des Hochstromtransformators 9 liegt die Spannung $u_1$ an, hier fließt der Strom $i_1$.

Der Hochstromtransformator 9 ist durch eine geringere Windungszahl in der Spule der Sekundärseite gegenüber der Spule der Primärseite gekennzeichnet, so dass die an der Sekundärseite erzeugte Spannung $u_2$ zwar niedriger, der hier fließende Strom $i_2$ jedoch höher ist. Die Sekundärseite des Hochstromtransformators 9 ist über einen weiteren, mit $V_{B,i2}$ bezeichneten Sperrthyristor 7 in Schaltrichtung mit der Schaltung des Prüflings verbunden, d. h. ein Pol der Sekundärseite des Hochstromtransformators 9 ist wiederum mit der Erdung 18 verbunden, der andere Pol des Hochstromtransformators 9 über den Sperrthyristor 7 mit dem Eintritt der Schaltung des Prüflings, d. h. dem Sättigungsdrosselventil 12.

Wie bereits beschrieben bilden die insgesamt $n_{VSC}$ VSC-Module 16 zentrale Elemente innerhalb der synthetischen Prüfschaltung 20. Sie sind identisch ausgebildet. Ihr Aufbau wird anhand der FIG 2 erläutert.

FIG 2 zeigt den Schaltplan eines der VSC-Module 16. Das VSC-Modul 16 hat zwei externe Anschlüsse 24, bezeichnet mit A und B, und umfasst im bevorzugten Ausführungsbeispiel vier normalleitende Bipolartransistoren mit isolierter Gate-Elektrode (englisch: Insulated-Gate bipolar Transistor, kurz IGBT) 25, denen jeweils eine Freilaufdiode 26 zum Schutz vor einer Überspannung beim Abschalten parallel geschaltet ist. Prinzipiell sind aber auch andere Arten von Transistoren verwendbar.

Die IGBTs 26 sind mit einem Kondensator 27 mit der Kapazität $C_{VSC}$ als zentrales Element in der Art einer Vollbrücke verschaltet, d. h. jeweils zwei in gleicher Richtung seriell geschaltete IGBTs 25, zwischen denen einer der externen Anschlüsse 24 angeordnet ist, sind in gleicher Richtung miteinander und zum Kondensator 27 parallel geschaltet. Die IGBTs 25 stellen Schalter $S_1...S_4$ dar, die mittels einer nicht weiter dargestellten Steuerelektronik einzeln ansteuerbar/ schaltbar sind. Dadurch kann die am Kondensator 27 anliegende Spannung $U_C$ in beliebiger Richtung auf die externen Anschlüsse 24 zwischen A und B geschaltet werden. Zwischen den Anschlüssen 24 A und B liegt demnach je nach Schaltzustand der Schalter $S_1...S_4$, d. h. der IGBTs 25, entweder $+U_C$, $-U_C$ oder 0 V an. Jede Stromrichtung ist dabei möglich.

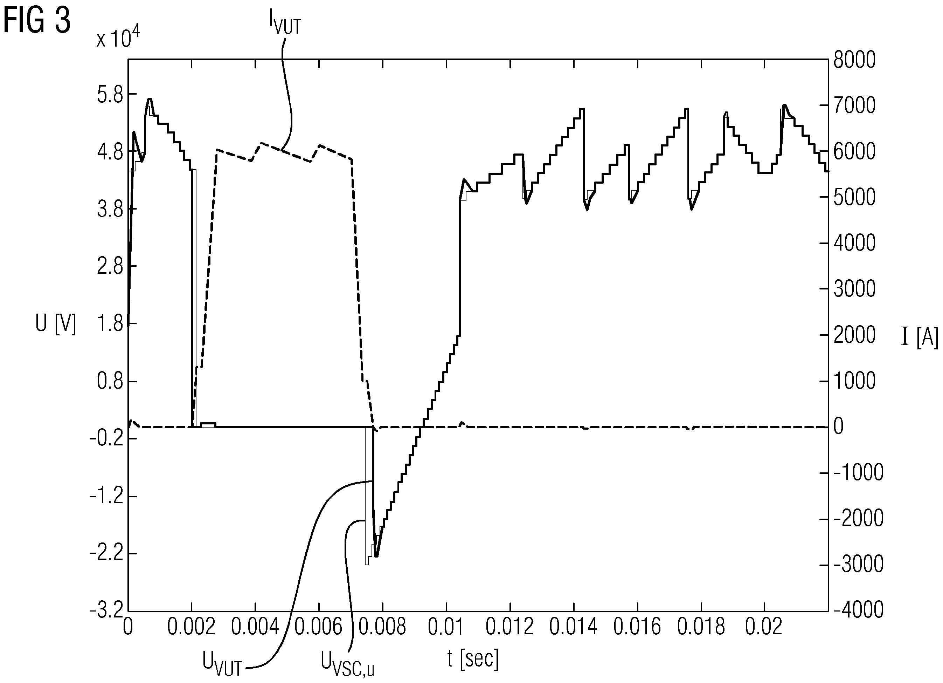

Nachdem anhand der FIG 1 und der FIG 2 die Struktur der synthetischen Prüfschaltung 20 beschrieben wurde, wird nunmehr im Folgenden das Prüfverfahren unter anderem anhand der FIG 3 beschrieben. Die Funktionsweise und die Interaktion der verschiedenen Komponenten aus der FIG 1 und der FIG 2 werden dabei ebenfalls beschrieben.

Die Hochgleichspannungsquelle 21 im linken Bereich der FIG 1 ist wie bereits beschrieben an ein dreiphasiges 20-kV-Drehstromnetz angeschlossen sowie mit der Reihenschaltung der VSC-Module 16 verbunden. Die Hochgleichspannungsquelle 21 hat somit die Aufgabe, die VSC-Module 16 abhängig von den Verlusten in der synthetischen Prüfschaltung 20 aufzuladen.

Während des Anfahrprozesses der synthetischen Prüfschaltung 20 sind die Kondensatoren 27 der VSC-Module 16 nicht geladen und somit nicht ansteuerbar. Die verwendeten VSC-Module 16 der Anmelderin im Ausführungsbeispiel haben eine Nennspannung von 1,6 kV und einen Nennstrom von 1 kA. In dem im Folgenden beschriebenen Ausführungsbeispiel sind 54 VSC-Module 16 vorgesehen und die Spannung der Hochgleichspannungsquelle 21 beträgt 50 kV.

Im Anfahrprozess sind die Ladewiderstände 17 aktiv, das Sperrventil 6 wird gezündet und aufgrund der beschriebenen Struktur laden sich somit die Kondensatoren 27 der VSC-Module 16 auf eine Spannung $U_C = U_{DC} / n_{VSC}$ = ca. 920 V auf. Sobald in jedem der VSC-Module 16 eine Spannung von etwa 800 V erreicht wird, wird die Steuerelektronik der VSC-Module 16 aktiv und die IGBTs 25 der VSC-Module 16 sind als Schalter $S_1...S_4$ steuerbar. Die VSC-Module 16 können somit graduell auf die gewünschte Nennspannung von 1,6 kV gebracht werden, indem bereits geladene VSC-Module 16 in ihrer Polung verändert werden, so dass sich ihre Spannung beim Laden der übrigen VSC-Module 16 zur Spannung der Hochgleichspannungsquelle 21 addiert.

Sobald der Anfahrprozess beendet ist, wird die Hochgleichspannungsquelle 21 ausgeschaltet und das Sperrventil 6 geht in einen Sperrzustand. Durch entsprechende zeitliche Ansteuerung der Steuerelektronik der VSC-Module 16 im Hochspannungskreis 22 kann der Prüfling nunmehr mit beliebigen Spannungsverläufen beschaltet werden, die innerhalb der Grenzen von $+n_{VSC,u}$ * 1,6 kV und $-n_{VSC,u}$ * 1,6 kV liegen und mit 1,6 kV diskretisiert sind.

Die FIG 3 zeigt in einer graphischen Darstellung einen derartigen Spannungs- und Stromverlauf. In dem Graph sind über einen Zeitraum von 0 bis 0,022 Sekunden die Spannungen $U_{VSC,u}$ (Spannung über der Reihe 29 der VSC-Module 16 im Hochspannungskreis 22) und $U_{VUT}$ (Spannung über die Schaltung des Prüflings) auf einer Skala von -32 kV bis +64 kV und der Strom $I_{VUT}$ (Strom über die Schaltung des Prüflings) auf einer Skala von -4000 A bis +8000 A aufgetragen. Nicht aufgetragen ist die Spannung über der Reihe 30 der VSC-Module 16 im Hochstromkreis 22, diese wird jedoch anhand der folgenden Beschreibung offenbart. Der Graph wurde anhand einer Simulation ermittelt.

Das beschriebene Verhalten des Hochspannungskreises 22 ist im rechten Teil der FIG 3, ab einem Zeitraum >8 ms dargestellt. Der Hochstromkreis 23 ist im Bereich von >8 ms nicht aktiv und eine typische Ventilspannungskurve $U_{VSC,u}$, wie sie in Stromrichtern für die Hochspannungs-Gleichstrom-Übertragung während des Wechselrichterbetriebs auftritt, wird durch die Ansteuerung der Steuerelektroniken der VSC-Module 16 im Hochspannungskreis 22 und dadurch resultierende Betätigung der jeweiligen Schalter $S_1...S_4$ erzeugt. Mit dieser Hochspannungskurve kann der Prüfling umfassend getestet werden.

Der Hochstromkreis 23 operiert in ähnlicher Weise: Durch die VSC-Module 16 im Hochstromkreis 23 können analog zum Hochspannungskreis 22 beliebige Spannungsverläufe $U_{VSC,i}$ an der Primärseite des Hochstromtransformators 9 über die entsprechende Ansteuerung der Steuerelektroniken erzeugt werden. Da die Nennspannung eines verwendeten IGBTs 25 lediglich 1 kA beträgt, erhöht der Hochstromtransformator 9 den Strom auf den benötigen Maximalwert von etwa 6 kA. Das Sperrthyristorpaar 8 sperrt die Spannung der VSC-Module 16 vom Hochstromtransformator 9 ab, während diese geladen werden. Der Sperrthyristor 7 sperrt die Spannung des Hochspannungskreises 22 vom Hochstromkreis 23 ab, wenn letzterer nicht aktiv ist.

Sobald mittels entsprechender Ansteuerung der Steuerelektroniken der VSC-Module 16 im Hochstromkreis 23 eine positive Spannung an den Primärkreis des Hochstromtransformators 9 angelegt wird, und der Prüfling gezündet wird, beginnt der Primärstrom $i_1$ gemäß der folgenden Gleichung anzusteigen:

$$i_1 = \frac{1}{L_t} \int U_{VSC,i}\,(t)\,dt$$

Hierbei ist $U_{VSC,i}(t)$ der Spannungsverlauf über der Reihe 30 der $n_{VSC,i}$ VSC-Module 16 im Hochstromkreis 23 und $L_t$ die Kurzschluss-Blindinduktivität des Hochstromtransformators 9. Mit dem Primärstrom $i_1$ steigt auch der Sekundärstrom $i_2$ mit $i_2 = i_1 * N_t$ an, wobei $N_t$ das Wicklungsverhältnis des Hochstromtransformators 9 ist.

Um ein realistisches Schaltverhalten des Prüflings zu emulieren, wird der Prüfling gezündet, während der Hochspannungskreis 22 aktiv ist. Im Graph der FIG 3 erfolgt dies bei ca. 2 ms. In der Folge steigt der Strom bis auf ca. 1 kA an, was dem maximalen Strom der VSC-Module 16 entspricht, erkennbar an der Stufe zwischen ca. 2 ms und ca. 2,3 ms im Graph der FIG 3.

Sodann wird die Spannung $U_{VSC,u}$ auf 0 V gesetzt und der Strom fließt als Freilaufstrom durch den Prüfling und die VSC-Module 16 des Hochspannungskreises 22. Bei ca. 2,3 ms im Graph der FIG 3 wird der Hochstromkreis 23 aktiv geschaltet und baut die gewünschte Stromstärke von etwa 6 kA auf. Sobald diese maximale Stromstärke erreicht ist, wird die Spannung $U_{VSC,i}$ auf 0 V gesetzt und der Strom fließt als Freilaufstrom durch den Prüfling und die VSC-Module 16 des Hochstromkreises 23. Somit ergibt sich der vollständige, durch den Prüfling fließende Strom $I_{VUT}$ als Summe aus den Strömen des Hochspannungskreises 22 und des Hochstromkreises 23.

Aufgrund der Verluste im Sperrthyristor 7 und dem Sperrthyristorpaar 8 sinkt der Strom während der aktiven Phase des Hochstromkreises 23 ab. Daher ist es während der aktiven Phase des Hochstromkreises 23 wiederkehrend erforderlich, den Hochstromtransformator 9 mit positiver Spannung zu versorgen, um den Strom wieder auf den gewünschten Wert zu bringen. Dies erfolgt wiederum durch kurze entsprechende Ansteuerung der VSC-Module 16 des Hochstromkreises 23 und kann einige Male abhängig von der Stärke des Stromabfalls erfolgen, d. h. wenn der Strom unter einen bestimmten, nicht mehr akzeptablen vorgegebenen Wert sinkt. Im Ausführungsbeispiel erfolgt dies zweimal bei ca. 3,8 ms und 5,6 ms im Graph der FIG 3.

Zum Abschluss der Hochstromprüfung des Prüflings wird eine negative Spannung an der Primärseite des Hochstromtransformators 9 angelegt. Dies erfolgt im Ausführungsbeispiel bei ca. 7 ms im Graph der FIG 3. Der Strom beginnt nach der oben angegebenen Gleichung zu sinken. Sobald der Strom des Hochstromtransformators 9 auf 0 A absinkt, geht der Sperrthyristor 7 in einen Sperrzustand. Daraufhin wird aus dem Hochspannungskreis 22 eine negative Spannung $U_{VSC,u}$ am Prüfling angelegt, wiederum durch entsprechende Ansteuerung der VSC-Module 16 des Hochspannungskreises 22. Dies erfolgt im Ausführungsbeispiel bei ca. 7,5 ms im Graph der FIG 3.

Infolge der negativen Spannung sinkt der Strom im Hochspannungskreis 22 und erreicht 0 A nach einem kurzen Sperrverzögerungsstrom. Hierdurch geht der Prüfling in einen Sperrzustand und die Prüfung kann mit der bereits beschriebenen Hochspannungsprüfung fortgesetzt werden.

Bezugszeichenliste

1    dreiphasige Spannungsquelle
2    Netzimpedanz
3    Dreiphasentransformator
4    Kommutierungsimpedanz
5    Sechspulsgleichrichter
6    Sperrventil
7    Sperrthyristor
8    Sperrthyristorpaar
9    Hochstromtransformator
10   Kommutierungsdrossel
11   Hochleistungs-Halbleiterelement
12   Sättigungsdrosselventil
13   Widerstand
14   Kondensator
15   Steuerkondensator
16   VSC-Modul
17   Ladewiderstand
18   Erdung
20   synthetische Prüfschaltung
21   Hochgleichspannungsquelle
22   Hochspannungskreis
23   Hochstromkreis
24   Anschluss
25   IGBT
26   Freilaufdiode
27   Kondensator
28   Hochspannungsquelle
29   erste Reihe
30   zweite Reihe
31   Anschluss

**Patentansprüche**

1. Prüfschaltung (20) für ein Hochleistungs-Halbleiterelement (11) in Stromrichtern der Hochspannungs-Gleichstrom-Übertragung, umfassend einen Hochspannungskreis (22) mit einem Anschluss (31) für das Hochleistungs-Halbleiterelement (11) und eine mit dem Hochleistungs-Halbleiterelement (11) verbindbare Hochspannungsquelle (28), wobei die Hochspannungsquelle (28) eine Mehrzahl von in einer ersten Reihe (29) geschalteten spannungsgeführten Stromrichtermodulen (16) umfasst, **dadurch gekennzeichnet, dass** die Prüfschaltung (20) eine in eine zweite Reihe (30) geschaltete Mehrzahl von spannungsgeführten Stromrichtermodulen (16) umfasst, die mit der Primärseite eines Hochstromtransformators (9) elektrisch verbunden sind, und die Sekundärseite des Hochstromtransformators (9) mit dem Hochleistungs-Halbleiterelement (11) elektrisch verbindbar ist.

2. Prüfschaltung (20) nach Anspruch 1, bei der die zweite Reihe (30) mit der ersten Reihe (29) in Serie geschaltet ist.

3. Prüfschaltung (20) nach einem der vorhergehenden Ansprüche, bei der die spannungsgeführten Stromrichtermodule (16) einen Kondensator (27) und vier Transistoren (25) in einer Vollbrücke umfassen.

4. Prüfschaltung (20) nach Anspruch 3, bei der die Transistoren (25) Bipolartransistoren mit isolierter Gate-Elektrode (25) sind.

5. Prüfschaltung (20) nach einem der vorhergehenden Ansprüche, bei der diespannungsgeführten Stromrichtermodule (16) für eine Nennspannung von mehr als 800 V und/oder einen Nennstrom von mehr als 500 A ausgelegt sind.

6.  Prüfschaltung (20) nach einem der vorhergehenden Ansprüche, die mehr als zehn, bevorzugt mehr als dreißig spannungsgeführte Stromrichtermodule (16) umfasst.

7.  Prüfschaltung (20) nach einem der vorhergehenden Ansprüche, umfassend einen netzgespeisten Gleichrichter (5), der mit der Hochspannungsquelle (28) verbindbar ist.

8.  Prüfschaltung (20) nach Anspruch 7, bei der dem Gleichrichter (5) ein Hochspannungstransformator (3) vorgeschaltet ist.

9.  Prüfschaltung (20) nach Anspruch 8, bei der der Hochspannungstransformator (3) für eine Ausgangsspannung von mehr als 25 kV ausgelegt ist.

10. Prüfschaltung (20) nach einem der vorhergehende Ansprüche, bei dem das Hochleistungs-Halbleiterelement (11) ein Thyristor (11) ist.

11. Verfahren zur Prüfung eines Hochleistungs-Halbleiterelements (11), bei dem eine Prüfverlaufsspannungskurve für eine Hochspannungsprüfung des Hochleistungs-Halbleiterelements (11) vorgegeben wird, und bei dem die vorgegebene Prüfverlaufsspannungskurve durch Ansteuerung von spannungsgeführten Stromrichtermodulen (16) in einer ersten Reihe (29) nachgebildet wird,
    **dadurch gekennzeichnet, dass**
    eine Prüfverlaufsstromkurve für eine Hochstromprüfung des Hochleistungs-Halbleiterelements (11) vorgegeben wird, und
    die vorgegebene Prüfverlaufsstromkurve durch Ansteuerung von spannungsgeführten Stromrichtermodulen (16) in einer zweiten Reihe nachgebildet wird, wobei ein Hochstromtransformator mittels einer Spannung der zweiten Reihe von spannungsgeführten Stromrichtermodulen angesteuert wird, und wobei durch den Hochstromtransformator der an dessen Primärseite fließende Strom vervielfacht wird.

**Claims**

1.  Test circuit (20) for a high-power semiconductor element (11) in power converters for high-voltage direct-current power transmission, comprising a high-voltage circuit (22) with a terminal (31) for the high-power semiconductor element (11) and a high-voltage source (28) that can be connected to the high-power semiconductor element (11),
    wherein the high-voltage source (28) comprises a plurality of voltage-controlled power converter modules (16) connected in a first series (29),
    **characterized in that**
    the test circuit (20) comprises a plurality of voltage-controlled power converter modules (16) connected in a second series (30), which are electrically connected to the primary side of a high-current transformer (9), and the secondary side of the high-current transformer (9) can be electrically connected to the high-power semiconductor element (11).

2.  Test circuit (20) according to Claim 1, in which the second series (30) is connected in series with the first series (29).

3.  Test circuit (20) according to either of the preceding claims, in which the voltage-controlled power converter modules (16) comprise a capacitor (27) and four transistors (25) in a full bridge.

4.  Test circuit (20) according to Claim 3, in which the transistors (25) are bipolar transistors with an insulated gate electrode (25).

5.  Test circuit (20) according to one of the preceding claims, in which the voltage-controlled power converter modules (16) are designed for a rated voltage of more than 800 V and/or a rated current of more than 500 A.

6.  Test circuit (20) according to one of the preceding claims, comprising more than ten, preferably more than thirty, voltage-controlled power converter modules (16).

7.  Test circuit (20) according to one of the preceding claims, comprising a grid-supplied rectifier (5) that can be connected to the high-voltage source (28).

8.  Test circuit (20) according to Claim 7, in which a high-voltage transformer (3) is connected upstream of the rectifier (5) .

9.  Test circuit (20) according to Claim 8, in which the high-voltage transformer (3) is designed for an output voltage of more than 25 kV.

10. Test circuit (20) according to one of the preceding claims, in which the high-power semiconductor element (11) is a thyristor (11).

11. Method for testing a high-power semiconductor element (11), in which a test voltage curve is specified for a high-voltage testing of the high-power semiconductor element (11), and in which the specified test voltage curve is simulated by the driving of voltage-controlled power converter modules (16) in a first series (29),
    **characterized in that**
    a test current curve is specified for a high-current testing of the high-power semiconductor element (11), and the specified test current curve is simulated by the driving of voltage-controlled power converter modules (16) in a second series, wherein a high-current transformer is driven by means of a voltage of the second series of voltage-controlled power converter modules, and wherein the current flowing on the primary side of the high-current transformer is multiplied by said transformer.

**Revendications**

1. Circuit (20) de contrôle d'un élément (11) à semi-conducteur de grande puissance dans des convertisseurs du transport de courant continu de haute tension, comprenant un circuit (22) de haute tension ayant une borne (31) pour l'élément (11) semi-conducteur de grande puissance et une source (28) de haute tension pouvant être connectée à l'élément (11) semi-conducteur de grande puissance,
dans lequel la source (28) de haute tension comprend une pluralité de modules (16) de convertisseur mis sous tension montés suivant une première rangée (29),
**caractérisé**
**en ce que** le circuit (20) de contrôle comprend une pluralité, monté suivant une deuxième rangée (30), de modules (16) de convertisseur mis sous tension, qui sont connectés électriquement au côté primaire d'un transformateur (9) de courant fort, et le côté secondaire du transformateur (9) de courant fort peut être connecté électriquement à l'élément (11) semi-conducteur de grande puissance.

2. Circuit (20) de contrôle suivant la revendication 1, dans lequel la deuxième rangée (30) est montée en série avec la première rangée (29).

3. Circuit (20) de contrôle suivant l'une des revendications précédentes, dans lequel les modules (16) de convertisseur mis sous tension comprennent un condensateur (27) et quatre transistors (25) en un circuit en pont.

4. Circuit (20) de contrôle suivant la revendication 3, dans lequel les transistors (25) sont des transistors bipolaires à électrode (25) de grille isolée.

5. Circuit (20) de contrôle suivant l'une des revendications précédentes, dans lequel les modules (16) de convertisseur mis sous tension sont conçus pour une tension nominale de plus de 800 V et/ou pour un courant nominal de plus de 500 A.

6. Circuit (20) de contrôle suivant l'une des revendications précédentes, qui comprend plus de dix, de préférence plus de trente, modules (16) de convertisseur mis sous tension.

7. Circuit (20) de contrôle suivant l'une des revendications précédentes, comprenant un redresseur (5) alimenté par le réseau, qui peut être connecté à la source (28) de haute tension.

8. Circuit (20) de contrôle suivant la revendication 7, dans lequel un transformateur (3) de haute tension est monté en amont du redresseur (5).

9. Circuit (20) de contrôle suivant la revendication 8, dans lequel le transformateur (3) de haute tension est conçu pour une tension de sortie de plus de 25 kV.

10. Circuit (20) de contrôle suivant l'une des revendications précédentes, dans lequel l'élément (11) à semi-conducteur de grande puissance est un thyristor (11).

11. Procédé de contrôle d'un élément (11) à semi-conducteur de grande puissance, dans lequel on prescrit une courbe de tension de déroulement du contrôle pour un contrôle de haute tension de l'élément (11) à semi-conducteur de grande puissance, et dans lequel on reproduit la courbe de tension de déroulement de contrôle donnée à l'avance en commandant des modules (16) de convertisseur mis sous tension suivant une première rangée (29), **caractérisé en ce que**
on prescrit une courbe de courant de déroulement du contrôle pour un contrôle de courant fort de l'élément (11) à semi-conducteur de grande puissance et on reproduit la courbe de courant de déroulement du contrôle donnée à l'avance en commandant des modules (16) de convertisseur mis sous tension dans une deuxième rangée, dans lequel on commande un transformateur de courant fort au moyen d'une tension de la deuxième rangée de module de convertisseur mis sous tension et dans lequel on multiplie par le transformateur de courant fort le courant passant à son côté primaire.

**FIG 1**

FIG 2

FIG 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2010145692 A1
- CN 103197241 A
- CN 102129034 B
- CN 102565579 B

**In der Beschreibung aufgeführte Nicht-Patentliteratur**

- Thyristor valves for high voltage direct current (HVDC) power transmission, Part1: Electrical Testing. *IEC 60700-1,* 2008
- Static var compensators (SVC) - Testing of thyristor valves,'' IEC (International Electrotechnical Commission). *IEC 61954,* 2011
- IEEE 857, Guide for Testing of Thyristor Valves. IEEE (Institute of Electrical and Electronics Engineers), 1996